(19) **Europäisches Patentamt**

**European Patent Office**

**Office européen des brevets**

(11) **EP 1 192 709 B1**

(12) **EUROPÄISCHE PATENTSCHRIFT**

(45) Veröffentlichungstag und Bekanntmachung des Hinweises auf die Patenterteilung:
**30.07.2003 Patentblatt 2003/31**

(21) Anmeldenummer: **00945564.3**

(22) Anmeldetag: **25.05.2000**

(51) Int Cl.⁷: **H03D 3/00**

(86) Internationale Anmeldenummer:
**PCT/DE00/01687**

(87) Internationale Veröffentlichungsnummer:
**WO 01/003284 (11.01.2001 Gazette 2001/02)**

(54) **VORRICHTUNG UND VERFAHREN ZUM DEMODULIEREN FREQUENZMODULIERTER SIGNALE**

DEVICE AND METHOD FOR DEMODULATING FREQUENCY-MODULATED SIGNALS

DISPOSITIF ET PROCEDE DE DEMODULATION DE SIGNAUX MODULES EN FREQUENCE

(84) Benannte Vertragsstaaten:
**DE FR GB**

(30) Priorität: **30.06.1999 DE 19930227**

(43) Veröffentlichungstag der Anmeldung:
**03.04.2002 Patentblatt 2002/14**

(73) Patentinhaber: **Infineon Technologies AG**
**81669 München (DE)**

(72) Erfinder:
• **WAASEN, Stefan, Van**
**D-47178 Duisburg (DE)**
• **PUMA, Giuseppe, Li**
**D-44791 Bochum (DE)**

(74) Vertreter: **Epping Hermann & Fischer**
**Ridlerstrasse 55**
**80339 München (DE)**

(56) Entgegenhaltungen:
**EP-A- 0 576 082       EP-A- 0 797 292**
**EP-A- 0 901 223       GB-A- 1 530 602**

**Beschreibung**

Die vorliegende Erfindung betrifft eine Vorrichtung und ein Verfahren zur Demodulation eines frequenzmodulierten Signals, bei dem das frequenzmodulierte Signal in orthogonale Komponenten bei einer Zwischenfrequenz umgesetzt wird.

Eine Vorrichtung und ein Verfahren dieser Art kommen beispielsweise bei der Demodulation eines frequenzmodulierten Signals unter Verwendung des sogenannten Quadricorrelators zum Einsatz.

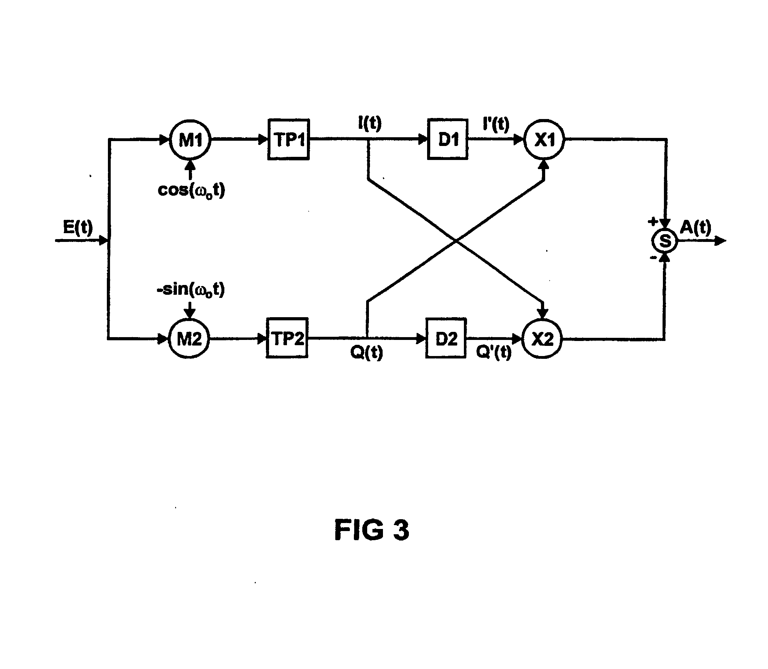

Der prinzipielle Aufbau eines Quadricorrelators ist in Figur 3 veranschaulicht. Eine vergleichbare Demodulatorschaltung ist in der GB-A-1 530 602 gezeigt. Der gezeigte Quadricorrelator umfaßt einen ersten Mischer M1, einen zweiten Mischer M2. einen ersten Tiefpaß-Filter TP1, einen zweiten Tiefpaß-Filter TP2, ein erstes Differenzierglied D1, ein zweites Differenzierglied D2, einen ersten Multiplizierer X1, einen zweiten Multiplizierer X2, und einen Subtrahierer S, die wie in der Figur 3 gezeigt verschaltet sind. Das zu demodulierende Signal ist mit E(t) bezeichnet, und das demodulierte Signal ist mit A(t) bezeichnet.

Durch den ersten Mischer M1 und den diesem nachgeschalteten Tiefpaß-Filter TP1 wird das zu demodulierende Signal E(t) in ein Signal I(t) mit einer vorbestimmten Zwischenfrequenz umgesetzt. Dabei multipliziert der erste Mischer M1 das zu demodulierende Signal E(t) mit $\cos(\omega_0 t)$, und der Tiefpaß-Filter TP1 filtert bei der Mischung entstandene, aber für die weitere Verarbeitung nicht erforderliche oder störende Komponenten des daraus resultierenden Ergebnisses heraus. Das Signal I(t) wird durch den ersten Differenzierer D1 differenziert, wodurch ein differenziertes Signal I'(t) entsteht.

Durch den zweiten Mischer M2 und den diesem nachgeschalteten Tiefpaß-Filter TP2 wird das zu demodulierende Signal E(t) in ein Signal Q(t) mit einer vorbestimmten Zwischenfrequenz umgesetzt. Die Signale I(t) und Q(t) sind zueinander orthogonale Signalkomponenten. I(t) wird als Inphasenkomponente, Q(t) als Quadraturkomponente bezeichnet. Dabei multipliziert der zweite Mischer M2 das zu demodulierende Signal E(t) mit $-\sin(\omega_0 t)$, und der Tiefpaß-Filter TP2 filtert bei der Mischung entstandene, aber für die weitere Verarbeitung nicht erforderliche oder störende Komponenten des daraus resultierenden Ergebnisses heraus. Das Signal Q(t) wird durch den zweiten Differenzierer D2 differenziert, wodurch ein differenziertes Signal Q'(t) entsteht.

Der erste Multiplizierer X1 multipliziert das Signal I'(t) mit dem Signal Q(t).

Der zweite Multiplizierer X2 multipliziert das Signal Q'(t) mit dem Signal I(t).

Die Ausgangssignale der Multiplizierer X1 und X2 werden dem Subtrahierer S zugeführt. Dieser bildet die Differenz I'(t)·Q(t) - I(t)·Q'(t) und gibt diese als das demodulierte Signal A(t) aus.

Bezüglich weiterer Einzelheiten zum Aufbau, der Funktion und der Wirkungsweise von Quadricorrelatoren wird auf Floyd M. Gardner: Characteristics of Frequency-Tracking Loops in: Phase-Locked Loops, Editors: W.C. Lindsey, C.M. Chie, New York, IEEE Press, 1986, Seiten 226 bis 240 verwiesen.

Quadricorrelatoren werden insbesondere bei Verwendung von sogenannten Low-IF-Strukturen (bei der Verwendung von niedrigen Zwischenfrequenzen) sehr häufig eingesetzt. Die Differenzierglieder werden dabei üblicherweise durch Hochpaß- oder Tiefpaß-Filter realisiert.

Die Demodulation frequenzmodulierter Signale unter Verwendung eines Quadricorrelators führt rein theoretisch mit einem verhältnismäßig geringen Aufwand zu hervorragenden Ergebnissen. In der Praxis treten aber mitunter diverse Probleme auf. Das demodulierte Signal kann insbesondere Nichtlinearitäten im Frequenzbereich aufweisen (hohe Frequenzen werden mitunter anders gewichtet als niedrige Frequenzen), ein starkes und/oder ungleichmäßig verteiltes Rauschen aufweisen und/oder eine nachträgliche Offsetkorrektur erfordern. Diese Probleme lassen sich - wenn überhaupt - nur mit einem relativ hohen Aufwand verhindern bzw. eliminieren.

In der DE-A1-197 38 363 ist ein Empfänger für Mobilfunksysteme beschrieben, bei dem Quadraturkomponenten mittels eines Polyphasen-Filters gefiltert, anschließend in einer AGC-Stufe verstärkt und anschließend demoduliert werden. Der Demodulator umfaßt jeweilige Mischer, denen je eine Ausgangssignalkomponente der AGC-Stufe direkt sowie über eine Kreuzkopplung die andere Ausgangssignalkomponente der AGC-Stufe differenziert zugeführt werden. Das demodulierte Ausgangssignal wird durch subtraktive Überlagerung der Ausgangssignale der Mischer erhalten.

In der US-A-4 342 000 ist ein Dektektor für frequenzmodulierte Signale gezeigt, der einen Mischer enthält, dem einerseits Eingangssignalkomponenten direkt und andererseits Eingangssignalkomponenten über ein Phasenschiebeglied zugeführt werden. Im Hinblick auf eine Übertragungskennlinie der Schaltung liegen für Phasenverschiebung und differentielle Verstärkung Symmetrien in Bezug auf eine Zwischenfrequenz vor.

In der EP-A-0 797 292 ist ein Empfängerschaltkreis gezeigt, bei dem das Eingangssignal in orthogonale Komponenten umgesetzt wird. Die orthogonalen Komponenten werden kapazitiv an ein Polyphasen-Filter gekoppelt. Die Ausgänge des Polyphasen-Filters werden in einen Equalizer eingespeist.

Der vorliegenden Erfindung liegt die Aufgabe zugrunde, eine Vorrichtung und ein Verfahren der eingangs genannten Art derart weiterzubilden, daß sich damit zu demodulierende Signale mit minimalem Aufwand und dennoch selbst höchsten Anforderungen genügenden Ergebnissen demodulieren lassen.

Diese Aufgabe wird erfindungsgemäß durch die Merkmale der Vorrichtung nach dem Patentanspruch 1 bzw. des Verfahrens nach dem Patentanspruch 2 gelöst.

Demnach ist vorgesehen,

- daß ein Polyphasen-Filter und Mischer verwendet werden bzw.

- daß die Demodulator-Kennlinie punktsymmetrisch zur Zwischenfrequenz ausgerichtet wird.

Vorrichtungen und Verfahren dieser Art ermöglichen es, die zur Demodulation vorzunehmenden Maßnahmen symmetrisch zur Zwischenfrequenz erfolgen zu lassen. Durch die Beseitigung der in herkömmlichen Demodulatoren vorhandenen Asymmetrien ergibt sich eine ganze Reihe von Vorteilen:

- oberhalb und unterhalb der Zwischenfrequenz liegende (hohe und niedrige) Frequenzen werden gleich bewertet,

- das Rauschen ist stärker bandbegrenzt und im interessierenden Frequenzbereich gleichmäßiger verteilt,

- gegebenenfalls vorhandene Nichtlinearitäten wirken sich gleichermaßen auf hohe und auf niedrige Frequenzen aus, wodurch sie nicht mehr so kritisch sind, und

- es ist keine Offsetkorrektur mehr erforderlich.

Vorrichtungen und Verfahren der beanspruchten Art ermöglichen es also, zu demodulierende Signale mit minimalem Aufwand und optimalem Ergebnis zu demodulieren.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figuren näher erläutert.
Es zeigen

Figur 1     den Aufbau der vorliegend näher betrachteten Vorrichtung zur Demodulation frequenzmodulierter Signale,

Figur 2     den Aufbau eines in der Vorrichtung gemäß Figur 1 enthaltenen Polyphasen-Filters, und

Figur 3     den Aufbau einer herkömmlichen Vorrichtung zur Demodulation frequenzmodulierter Signale.

Die nachfolgend näher beschriebene Vorrichtung und das nachfolgend näher beschriebene Verfahren zur Demodulation frequenzmodulierter Signale werden im betrachteten Beispiel in einem nach dem DECT-Standard arbeitenden System verwendet. Es sei jedoch bereits an dieser Stelle darauf hingewiesen, daß hierauf keine Einschränkung besteht. Die beschriebene Vorrichtung und das beschriebene Verfahren können auch in beliebigen anderen Systemen eingesetzt werden.

Die beschriebene Vorrichtung ist eine neuartige praktische Realisierung des Quadricorrelators gemäß Figur 3. Es werden die Differenzierglieder D1 und D2 nicht mehr wie bisher durch Hochpaß-Filter oder Tiefpaß-Filter realisiert. Stattdessen wird ein sogenanntes Polyphasen-Filter verwendet, wobei ein Pol des Polyphasen-Filters betrachtet wird.

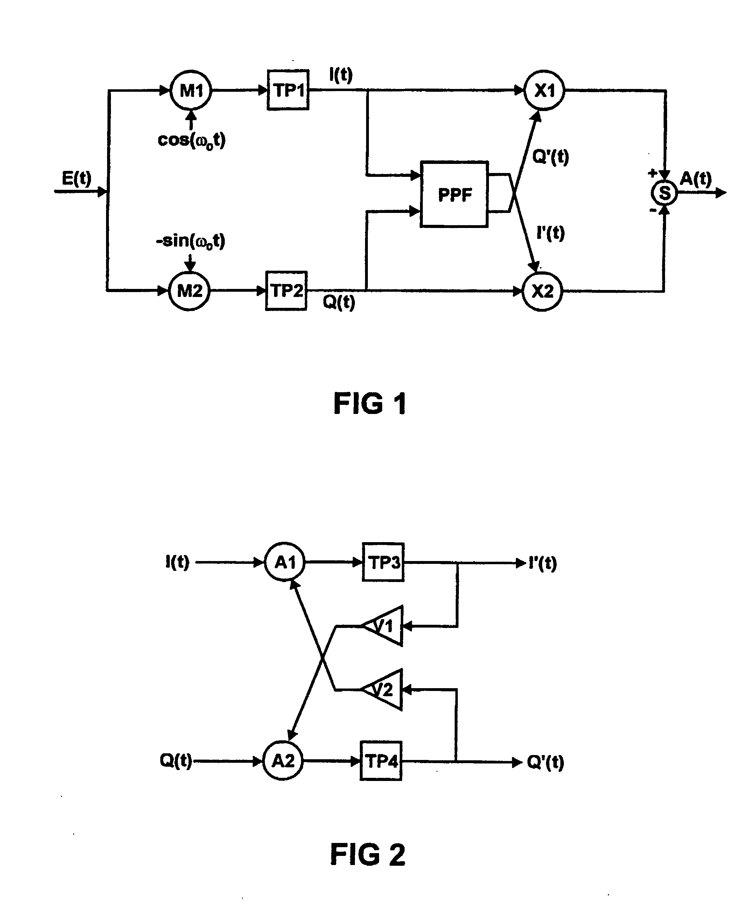

Der neuartige Demodulator ist in Figur 1 dargestellt.

Wie aus einer Gegenüberstellung der Figuren 1 und 3 ersichtlich ist, bleibt bei dem neuartigen Demodulator die Grundstruktur des Quadricorrelators gemäß Figur 3 erhalten. Mit den gleichen Bezugszeichen bezeichnete Elemente entsprechen einander und werden zur Vermeidung von Wiederholungen nicht nochmals beschrieben. Neu am Demodulator gemäß Figur 1 ist hingegen, daß die Differenzierglieder D1 und D2 entfallen und der bereits erwähnte, in der Figur 1 mit dem Bezugszeichen PPF bezeichnete Polyphasen-Filter verwendet wird.

Wie aus der Figur 1 ersichtlich ist, erhält der Polyphasen-Filter PPF die (nach wie vor vorhandenen) zueinander orthogonalen Signale I(t) und Q(t) und erzeugt daraus nach der Zeit differenzierte Signale I'(t) und Q'(t). Diese Signale werden durch die (nach wie vor vorhandenen) Multiplizierer X1 und X2 mit Q(t) bzw. I(t) multipliziert, und durch den (nach wie vor vorhandenen) Subtrahierer S voneinander subtrahiert. Das aus dem Demodulator gemäß Figur 1 ausgegebene (demodulierte) Signal A(t) ist damit wie bei dem in der Figur 3 gezeigten Quadricorrelator I'(t)·Q(t) - I(t)·Q'(t).

Der Aufbau des Polyphasen-Filters PPF ist in Figur 2 gezeigt. Er enthält im betrachteten Beispiel einen ersten Addierer A1, einen zweiten Addierer A2, einen ersten Tiefpaß-Filter TP3, einen zweiten Tiefpaß-Filter TP4, einen ersten Verstärker V1, und einen zweiten Verstärker V2.

Das in den Polyphasen-Filter PPF eingegebene Signal I(t) wird durch den ersten Addierer A1 zu dem aus dem zweiten Tiefpaß-Filter TP4 ausgegebenen und durch den zweiten Verstärker V2 verstärkten Signal addiert und durch den ersten Tiefpaß-Filter TP3 einer Tiefpaß-Filterung unterzogen; das aus dem ersten Tiefpaß-Filter TP3 ausgegebene Signal ist das Signal I'(t).

Das in den Polyphasen-Filter PPF eingegebene Signal Q(t) wird durch den zweiten Addierer A2 zu dem aus dem ersten Tiefpaß-Filter TP3 ausgegebenen und durch den ersten Verstärker V1 verstärkten Signal addiert und durch den zweiten Tiefpaß-Filter TP4 einer Tiefpaß-Filterung unterzogen; das aus dem zweiten Tiefpaß-Filter TP4 ausgegebene Signal ist das Signal Q'(t).

Der Polyphasen-Filter PPF führt nicht wirklich eine Differenzierung der Signale I(t) und Q(t) durch. Die ausgegebenen Signale I(t) und Q(t) entsprechen aber im vorliegend interessierenden Bereich mit hinreichender Genauigkeit dem Ergebnis einer Differenzierung.

Der Polyphasen-Filter PPF führt eigentlich "nur" eine Tiefpaß-Filterung aus. Allerdings kann über die (im folgenden mit k bezeichneten) Verstärkungsfaktoren der Verstärker V1 und V2 die Mittenfrequenz der Durchlaßkurve des Filters verschoben werden.

Bei einem normalen Tiefpaß liegt diese Mittenfrequenz der Durchlaßkurve bei 0 Hz, und die Durchlaßkurve verläuft punktsymmetrisch zu diesem Nullpunkt. Dies gilt auch für die im Polyphasen-Filter PPF enthaltenen Tiefpässe TP3 und TP4. Deren Durchlaßkurven sind allerdings durch die Kreuzkopplung (die Einkopplung des Ausgangssignals von TP3 an den Eingang von TP4, und die Einkopplung des Ausgangssignals von TP4 an den Eingang von TP3 abhängig von den Verstärkungsfaktoren k der in den Kreuzkopplungspfaden vorgesehenen Verstärker V1 und V2 verschiebbar.

Im betrachteten Beispiel werden die Mittenfrequenzen der Durchlaßkurven der Tiefpaßfilter so verschoben, daß sie auf der Zwischenfrequenz zu liegen kommen, auf welche das zu demodulierende Signal E(t) durch die Mischer M1 und M2 umgesetzt wurde.

Dies kann dadurch erreicht werden, daß man die Verstärkungsfaktoren k der Verstärker V1 und V2 auf $ZF/\omega_0$ einstellt, wobei ZF die Zwischenfrequenz bezeichnet, und wobei $\omega_0$ die Eckfrequenz der Tiefpässe bezeichnet. Dadurch stellt sich (wenn man $1/(1+j\omega/\omega_0)$ als Übertragungsfunktion der Tiefpässe TP3 und TP4 verwendet) eine Demodulator-Kennlinie

$$D = -\frac{(\omega - k \cdot \omega_0) / \omega_0}{1 + ((\omega - k \cdot \omega_0) / \omega_0)^2}$$

ein.

Diese Kennlinie ist punktsymmetrisch zur Zwischenfrequenz ($k \cdot \omega_0$).

Bezüglich weiterer Einzelheiten zu Aufbau, Betrieb, Funktion, und Wirkungsweise von Polyphasen-Filtern wird auf M. Steyaert, J. Crols: Analog Integrated Polyphase Filters, in: Analog Circuit Design, Editors: W. Sansen, J.H. Huijsing, R.J. Van de Plassche, Boston, Kluwer Academic Publishers, 1994, Vol. 3, Seiten 149-166 verwiesen.

Die punktsymmetrische Ausrichtung der Demodulatorkennlinie zur Zwischenfrequenz erweist sich in mehrfacher Hinsicht als vorteilhaft:

- oberhalb und unterhalb der Zwischenfrequenz liegende (hohe und niedrige) Frequenzen werden gleich bewertet,

- das Rauschen ist stärker bandbegrenzt und im interessierenden Frequenzbereich gleichmäßiger verteilt,

- gegebenenfalls vorhandene Nichtlinearitäten wirken sich gleichermaßen auf hohe und auf niedrige Frequenzen aus, wodurch sie nicht mehr so kritisch sind, und

- es ist keine Offsetkorrektur mehr erforderlich (der Demodulator liefert bei der Mittenfrequenz (der Zwischenfrequenz) den Wert Null.

Die beschriebene Vorrichtung und das beschriebene Verfahren ermöglichen es mithin, zu demodulierende Signale mit minimalem Aufwand und optimalem Ergebnis zu demodulieren.

**Patentansprüche**

1. Vorrichtung zur Demodulation eines frequenzmodulierten Signals (E(t)), bei der je ein Mischer (M1, M2) vorgesehen ist, um das frequenzmodulierte Signal (E(t)) in zueinander orthogonale Komponenten (I(t), Q(t)) bei einer Zwischenfrequenzlage umzusetzen, ein Polyphasen-Filter (PPF), dem eingangsseitig die orthogonalen Komponenten (I(t), Q(t)) zuführbar sind, und weitere Mischer (X1, X2), denen je eine der orthogonalen Komponenten (I(t), Q(t)) sowie jeweils dasjenige der Ausgangssignale (I'(t), Q'(t)) des Polyphasen-Filters (PPF) zuführbar sind, das aus dem anderen der orthogonalen Komponenten (Q(t), I(t)) durch Filterung durch das Polyphasen-Filter (PPF) erhalten wird.

2. Verfahren zur Demodulation eines frequenzmodulierten Signals (E(t)) unter Umsetzen desselben in zueinander orthogonalen Komponenten (I(t), Q(t)) bei einer vorbestimmten Zwischenfrequenz und unter Demodulation der zueinander orthogonalen Komponenten (I(t), Q(t)), **dadurch gekennzeichnet,daß** die Demodulator-Kennlinie punktsymmetrisch zur Zwischenfrequenz ausgerichtet wird, indem die zueinander orthogonalen Komponenten (I(t), Q(t)) polyphasengefiltert werden und jeweils eine der orthogonalen Komponenten (I(t), Q(t)) mit demjenigen der polyphasengefilterten Signale (Q'(t), I'(t)) gemischt wird, das durch Polyphasen-Filterung des anderen der orthogonalen Komponenten (I(t), Q(t)) erhalten wird.

3. Vorrichtung nach Anspruch 1, **dadurch gekennzeichnet, daß** der Durchlaßbereich des Polyphasen-Filters (PPF) symmetrisch zur Zwischenfrequenz ausgerichtet wird.

**4.** Vorrichtung nach Anspruch 1,
**dadurch gekennzeichnet,daß**
das Polyphasen-Filter (PPF) einen ersten und einen zweiten Addierer (A1, A2) enthält, daß den Addierern (A1, A2) jeweils eine der orthogonalen Komponenten ((I(t), Q(t)) zuführbar ist, daß das aus den Addierern (A1, A2) ausgegebene Signal je einem Tiefpaß (TP3, TP4) zuführbar ist, daß die Tiefpässe ausgangsseitig über jeweilige Verstärker (V1, V2) auf die Addierer (A1, A2) über Kreuz rückgekoppelt sind.

**5.** Vorrichtung nach Anspruch 4,
**dadurch gekennzeichnet,daß**
die Verstärkungsfaktoren der Verstärker (V1, V2) jeweils auf einen Wert eingestellt sind, der aus dem Quotienten der Zwischenfrequenz und der Eckfrequenz der jeweiligen Tiefpässe (TP3, TP4) gebildet ist.

**Claims**

**1.** Device for the demodulation of a frequency-modulated signal (E(t)), in which a respective mixer (M1, M2) is provided in order to convert the frequency-modulated signal (E(t)) into mutually orthogonal components (I(t), Q(t)) at an intermediate frequency, a polyphase filter (PPF), to which the orthogonal components (I(t)) can be fed on the input side, and further mixers (X1, X2), to which can be fed a respective one of the orthogonal components (I(t), Q(t)), and also in each case that output signal of the output signals (I'(t), Q'(t)) of the polyphase filter (PPF) which is obtained from the other of the orthogonal components (Q(t), I(t)) through filtering by the polyphase filter (PPF).

**2.** Method for the demodulation of a frequency-modulated signal (E(t)) with conversion thereof into mutually orthogonal components (I(t), Q(t)) at a predetermined intermediate frequency and with demodulation of the mutually orthogonal components (I(t), Q(t)),
**characterized in that**
the demodulator characteristic curve is oriented centrosymmetrically with respect to the intermediate frequency by the mutually orthogonal components (I(t), Q(t)) being subjected to polyphase filtering and in each case one of the orthogonal components (I(t), Q(t)) being mixed with that signal of the polyphase-filtered signals (Q'(t), I'(t)) which is obtained through polyphase filtering of the other of the orthogonal components (I(t), Q(t)).

**3.** Device according to Claim 1,
**characterized in that**
the passband of the polyphase filter (PPF) is oriented symmetrically with respect to the intermediate frequency.

**4.** Device according to Claim 1,
**characterized in that**
the polyphase filter (PPF) contains a first and a second adder (A1, A2), **in that** in each case one of the orthogonal components (I(t), Q(t)) can be fed to the adders (A1, A2), **in that** the signal output from the adders (A1, A2) can be fed to a respective low-pass filter (TP3, TP4), **in that** the low-pass filters, on the output side, are fed back in a cross-coupled manner to the adders (A1, A2) via respective amplifiers (V1, V2).

**5.** Device according to Claim 4,
**characterized in that**
the gain factors of the amplifiers (V1, V2) are in each case set to a value which is formed from the quotient of the intermediate frequency and the cut-off frequency of the respective low-pass filters (TP3, TP4).

**Revendications**

**1.** Dispositif de démodulation d'un signal (E(t)) modulé en fréquence, dans lequel il est prévu respectivement un mélangeur (M1, M2) pour transformer le signal (E(t)) modulé en fréquence en des composantes (I(t), Q(t)) orthogonales entre elles pour une position en fréquence intermédiaire, un filtre (PPF) polyphasé auquel peuvent être envoyées du côté entrée les composantes (I(t), Q(t)) orthogonales et des mélangeurs (X1, X2) supplémentaires auxquels peuvent être envoyées respectivement l'une des composantes (I(t), Q(t)) orthogonales, ainsi que respectivement celle des signaux (I'(t), Q'(t)) de sortie du filtre polyphasé, qui est obtenue à partir de l'autre des composantes (Q(t), I(t)) orthogonales par filtrage par le filtre (PPF) polyphasé.

**2.** Procédé de démodulation d'un signal (E(t)) modulé en fréquence par conversion de celui-ci en les composantes (I(t), Q(t)) orthogonales entre elles pour une fréquence intermédiaire déterminée à l'avance et avec démodulation des composantes (I(t), Q(t)) orthogonales entre elles,
**caractérisé en ce que** l'on rend la caractéristique du démodulateur symétrique par rapport à un point pour la fréquence intermédiaire en filtrant de manière polyphasée les composantes (I(t), Q(t)) orthogonales entre elles et en mélangeant respectivement l'une des composantes (I(t), Q(t)) orthogonales à celle des signaux (Q'(t), I'(t)) filtrés de manière polyphasée, qui est obtenue par le filtrage de manière polyphasée de l'autre des composantes (I(t), Q(t)) orthogonales.

3. Dispositif suivant la revendication 1,
   **caractérisé en ce que** l'on rend la bande de transmission du filtre (PPF) polyphasé symétrique pour la fréquence intermédiaire.

4. Dispositif suivant la revendication 1, **caractérisé en ce que** le filtre (PPF) polyphasé comporte un premier et un deuxième additionneurs (A1, A2) **en ce que** l'on peut envoyer aux additionneurs (A1, A2) respectivement l'une des composantes (I(t), Q(t)) orthogonales, **en ce que** le signal sortant des additionneurs (A1, A2) peut être envoyé à un filtre passe-bas (TP3, TP4) **en ce que** les filtres passe-bas sont rétrocouplés en croix du côté de la sortie aux additionneurs (A1, A2) par l'intermédiaire d'amplificateurs (V1, V2) respectifs.

5. Dispositif suivant la revendication 4, **caractérisé en ce que** les gains des amplificateurs (V1, V2) sont réglés respectivement à une valeur qui est formée par le quotient de la fréquence intermédiaire et de la fréquence de coupure du filtre passe-bas (TP3, TP4) respectif.

**FIG 1**

**FIG 2**

**FIG 3**